**Europäisches Patentamt**

**European Patent Office**

**Office européen des brevets**

(11) Veröffentlichungsnummer: **0 059 861**
A2

(12) **EUROPÄISCHE PATENTANMELDUNG**

(21) Anmeldenummer: **82101196.2**

(22) Anmeldetag: **18.02.82**

(51) Int. Cl.³: **H 05 K 7/18**
**H 05 K 9/00**

(30) Priorität: **07.03.81 DE 3108788**

(43) Veröffentlichungstag der Anmeldung:
**15.09.82 Patentblatt 82/37**

(84) Benannte Vertragsstaaten:
**AT CH DE LI NL**

(71) Anmelder: **Licentia Patent-Verwaltungs-GmbH**
**Theodor-Stern-Kai 1**
**D-6000 Frankfurt/Main 70(DE)**

(72) Erfinder: **Hirsch, Gerhard**
**Häfnersweg 66**
**D-7150 Backnang(DE)**

(72) Erfinder: **Hofmeister, Hagen, Ing. grad.**
**Neustädter Strasse 34**
**D-7054 Korb(DE)**

(72) Erfinder: **Busse, Heinz, Ing. grad.**
**Bromberger Strasse 17**
**D-7150 Backnang(DE)**

(74) Vertreter: **Schickle, Gerhard, Dipl.-Ing. et al,**
**Licentia Patent-Verwaltungs-GmbH Theodor-Stern-Kai**
**1**
**D-6000 Frankfurt/Main 70(DE)**

(54) **Gestelleinsatz für Geräte der Nachrichtentechnik.**

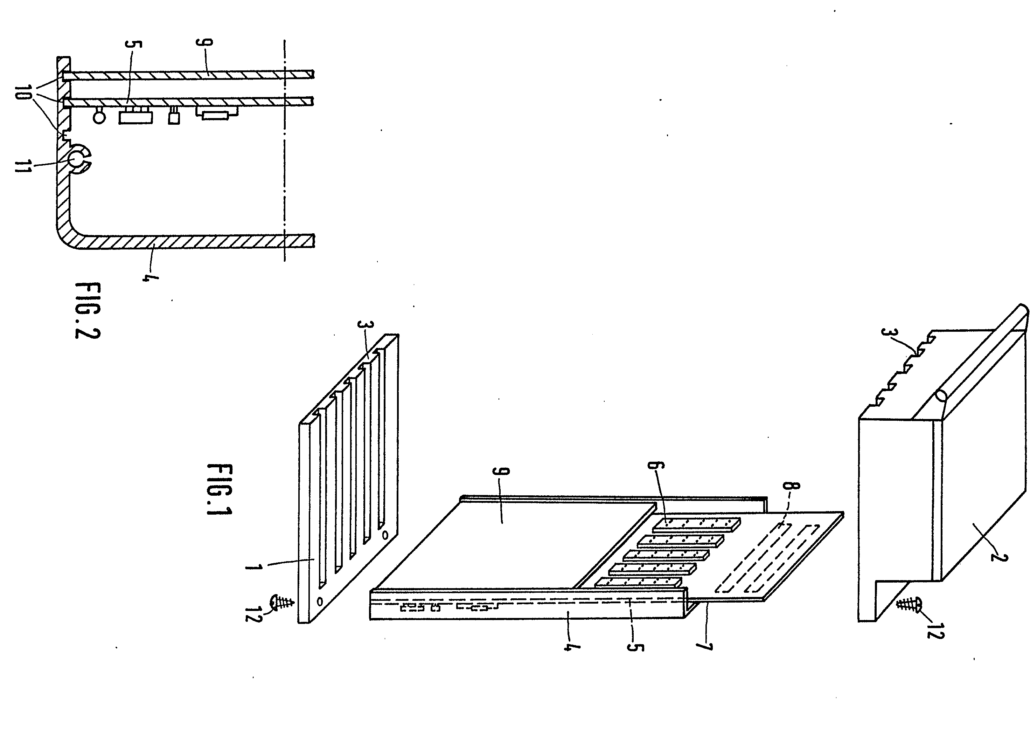

(57) Die Erfindung betrifft einen Gestelleinsatz zur Aufnahme von Elektronikeinschüben. Die Rückseite dieses Gestelleinsatzes bildet eine Kassette (4), in der die Verdrahtungskarte (5) mit Steckverbindern (6) für die in dem Einsatz angeordneten Elektronikeinschübe untergebracht ist. Gleichzeitig trägt diese Verdrahtungskarte, zu deren Abschirmung die Kassette dient, zentrale, die Einschübe versorgende Schaltungseinheiten. Hierdurch erreicht man, dass die Verbindungsleitungen von den zentralen Schaltungseinheiten zu den Einschüben möglichst kurz sind, worauf gerade bei sehr hohen Frequenzen bzw. Bitraten zu achten ist (Fig. 1).

FIG.1

EP 0 059 861 A2

Licentia Patent-Verwaltungs-GmbH          NE2-BK/Th/kön
Theodor-Stern-Kai 1                        BK 81/18
D-6000 Frankfurt 70


Gestelleinsatz für Geräte der Nachrichtentechnik


Die vorliegende Erfindung betrifft einen Gestelleinsatz zur
Aufnahme von Elektronikeinschüben, bestehend aus einem Bodenteil, einem Kopfteil und einer diese miteinander verbindenden Rückwand, wobei an der Rückwand eine Verdrahtungskarte mit Steckverbindern für die Einschübe angeordnet ist.

Nachrichtentechnische Schaltungseinheiten sind üblicherweise auf gedruckten Schaltungskarten angeordnet, die als
steckbare Einschübe in Einsätzen untergebracht sind. Die mit
mehreren Einschüben bestückten Einsätze sind für den Einbau
in Gestellen vorgesehen. An der Rückseite eines solchen Einsatzes befindet sich eine mit Steckverbindern versehene Verdrahtungskarte, auf die die Einschübe aufgesteckt und somit
untereinander elektrisch kontaktiert werden.

Zentrale Schaltungseinheiten, welche die übrigen Schaltungseinheiten mit z.B. Strom oder Trägerfrequenzen versorgen
oder sonstige zentrale Aufgaben übernehmen, sind bisher als ein Einschub unter den anderen in dem Einsatz angeordnet
worden. Diese Anordnung der zentralen Schaltungseinheiten erfordert unter Umständen recht lange Verbindungsleitungen zu
den übrigen Einschüben. Außerdem sind die Verbindungsleitungen zu den verschiedenen Einschüben unterschiedlich lang.
Dies kann aber gerade bei sehr hohen Frequenzen bzw. Bitraten zu Störungen führen.

Der Erfindung liegt daher die Aufgabe zugrunde, einen Gestelleinsatz der eingangs genannten Art anzugeben, bei dem die
zentralen Schaltungseinheiten mit einer Abschirmung versehen,
so angeordnet sind, daß die Verbindungsleitungen zu den Einschüben möglichst kurz und alle etwa gleich lang sind.

Die Aufgabe wird erfingungsgemäß dadurch gelöst, daß die
Rückwand aus einer Kassette besteht, in der die Verdrahtungskarte in dafür vorgesehenen Nuten eingesetzt ist, und daß die
Verdrahtungskarte oder eine oder mehrere zusätzliche in die
Kassette eingesetzte Druckschaltungskarte mit die Einschübe
versorgenden zentralen Schaltungseinheiten bestückt ist.

Zweckmäßige Ausführungen der Erfindung gehen aus den Unteransprüchen hervor.

Die als Kassette ausgebildete Rückwand dient vorteilhafterweise gleichzeitig als Verbindungselement zwischen dem Kopf-
und dem Bodenteil des Einsatzes.

Anhand eines in der Zeichnung dargestellten Ausführungsbeispiels wird nun die Erfindung näher erläutert. Dabei zeigt
die Fig. 1 eine Explosionsdarstellung des Gestelleinsatzes
und Fig. 2 einen Querschnitt durch die Kassette an der
Rückseite des Einsatzes.

Der in Fig. 1 dargestellte Einsatz besteht aus einem Bodenteil 1 und einem Kopfteil 2. Beide Teile sind mit Führungsnuten 3 versehen, in denen die Einschübe gehalten werden.
Die Rückwand des Einschubes, bildet eine nach dem Strangpreßverfahren hergestellte U-förmige Kassette 4. Sie weist mit
ihrer offenen Breitseite in das Innere des Einschubes. In die
Kassette ist eine Verdrahtungskarte 5 eingesetzt, die im oberen Abschnitt mit Steckverbindern 6 für die Einschübe versehen ist. Im unteren Bereich ist die Verdrahtungskarte mit
zentralen Schaltungseinheiten (durch einige Bauelemente angedeutet) belegt, die für alle oder die meisten Einschübe zugänglich sein sollen. Damit wird also der häufig noch auf der
Verdrahtungskarte vorhandene Platz ausgenutzt. Sollte der
Platz nicht ausreichen für die zentralen Schaltungseinheiten,
so können auch zusätzlich eine oder mehrere gedruckte Schaltungskarten in die Kassette eingesetzt werden. Die Anordnung
der zentralen Schaltungseinheiten direkt hinter den Einschüben ermöglicht den Einsatz von sehr kurzen und zu allen Einschüben führenden etwa gleich langen Verbindungsleitungen.
Die Kassette dient für diese zentralen Schaltungseinheiten
als HF-Abschirmung, die gerade bei hohen Frequenzen erforderlich ist. Über den oberen Kassettenrand hinaus ragt eine
Verlängerung 7 der Verdrahtungskarte 5, welche auf der nach
Außen gerichteten Seite mit Steckerleisten 8 besetzt ist
für den Anschluß der Gestellverdrahtung. Die Verlängerung
der Verdrahtungskarte wird an dem senkrechten Absatz 7' des
Kopfteils 2 des Einsatzes befestigt. Es ist zweckmäßig, die
Verlängerung 7 flexibel zu gestalten, damit sie bei einem
weiter zurückliegenden Absatz 7' an diesen herangebracht
werden kann.

Die offene Breitseite der Kassette 5 ist bei diesem Ausführungsbeispiel mit einer vor die Verdrahtungskarte 5 gesteckten Schirmwand 9 abgedeckt. Sie endet unterhalb der
auf der Innenseite der Verdrahtungskarte angeordneten Steckverbinder 6.

Die Fig. 2 zeigt einen Querschnitt durch die bezüglich der

0059861

strichpunktierten Linie symmetrische Kassette 4. In den beiden gegenüberliegenden Seiten sind Nuten 10 eingelassen,
zur Aufnahme der Schirmwand 9, der Verdrahtungskarte 5 und
einer evtl. zusätzlichen Druckschaltungskarte. Zudem sind die
Seitenwände der Kassette mit Schraubenkernlöchern 11 versehen
für selbstschneidende Gewindeschrauben 12, mit denen das
Kopfteil 2 und das Bodenteil 1 des Einsatzes an die Kassette
geschraubt werden.

- - - - - - - - - -

Licentia Patent-Verwaltungs-GmbH  NE2-BK/Th/kön
Theodor-Stern-Kai 1                BK 81/18
D-6000 Frankfurt 70


Patentansprüche


1. Gestelleinsatz zur Aufnahme von Elektronikeinschüben,
   bestehend aus einem Bodenteil, einem Kopfteil und einer
   diese miteinander verbindenden Rückwand, wobei an der
   Rückwand eine Verdrahtungskarte mit Steckverbindern für
   die Einschübe angeordnet ist, dadurch gekennzeichnet, daß
   die Rückwand aus einer Kassette (4) besteht, in der die
   Verdrahtungskarte (5) in dafür vorgesehenen Nuten (10)
   eingesetzt ist und daß die Verdrahtungskarte oder eine
   oder mehrere zusätzliche in die Kassette eingesetzte
   Druckschaltungskarten mit die Einschübe versorgenden
   zentralen Schaltungseinheiten bestückt sind.


2. Gestelleinsatz nach Anspruch 1, dadurch gekennzeichnet,
   daß die Kassette (4) als U-förmiges Strangpreßprofil
   ausgebildet ist, in dessen beiden gegenüberliegenden Seiten Nuten (10) zur Aufnahme der Verdrahtungskarte (5)
   und evtl. einer zusätzlichen Druckschaltungskarte eingelassen sind.

3. Gestelleinsatz nach Anspruch 1 oder 2, dadurch gekennzeichnet, daß die offene, in das Innere des Gestelleinsatzes, gerichtete Seite der Kassette (4) mittels einer
   Schirmwand (9), die ebenfalls in Nuten (10) in den Seitenwänden der Kassette eingesetzt werden kann, verschließbar ist.

4. Gestelleinsatz nach Anspruch 1, dadurch gekennzeichnet,
   daß die Verdrahtungskarte (5) eine oben aus der Kassette
   (4) herausragende Verlängerung (7) besitzt, an der Steckverbinder (8) für die Gestellverdrahtung angebracht sind.

5. Gestelleinsatz nach Anspruch 4, dadurch gekennzeichnet,
   daß die Verlängerung (7) der Verdrahtungskarte (5) flexibel ausgebildet ist.

FIG.1

FIG.2